# EUROPÄISCHE PATENTSCHRIFT

(11) **EP 0 920 788 B1**
(45) Veröffentlichungstag und Bekanntmachung des Hinweises auf die Patenterteilung: **05.06.2002**
(21) Anmeldenummer: 98916909.9
(22) Anmeldetag: 10.03.1998
(51) Int. Cl.: H05K 7/14

(54) **ELEKTRISCHES ODER ELEKTRONISCHES GERÄT**
ELECTRICAL OR ELECTRONIC DEVICE
APPAREIL ELECTRIQUE OU ELECTRONIQUE

(30) Priorität: 16.03.1997 DE 19710767
(43) Veröffentlichungstag der Anmeldung: 09.06.1999
(73) Patentinhaber: PHOENIX CONTACT GmbH & Co., 32825 Blomberg (DE)
(72) Erfinder: FEYE-HOHMANN, Jürgen, D-32756 Detmold (DE)
(74) Vertreter: Gesthuysen, Hans Dieter, Dipl.-Ing.
(86) Internationale Anmeldenummer: EP9801368
(87) Internationale Veröffentlichungsnummer: WO9842168

(56) Entgegenhaltungen:
- DE-C- 4 410 171
- GB-A- 2 014 367

## Beschreibung

Die Erfindung betrifft ein elektrisches oder elektronisches Gerät zum Aufsetzen auf eine Tragschiene, mit einem Gehäuse und mit einer im Gehäuse angeordneten Leiterplatte, wie es zum Beispiel aus DE-A-4 410 171 bekannt ist.

Ein elektrisches oder elektronisches Gerät der eingangs genannten Art ist aus der Praxis bereits seit langem bekannt. Zum Einbau der Leiterplatte wird diese in der Regel über eine entsprechende Führung im Gehäuse in dieses eingeschoben. Beim Einschieben kontaktiert die Leiterplatte in der Regel mit entsprechenden Kontakten, die im Gehäuse zum Anschluß der Leiterplatte vorgesehen sind. Nach dem Einsetzen der Leiterplatte wird das Gehäuse regelmäßig verschlossen. Erfolgt das Einschieben der Leiterplatte in das Gehäuse nicht sachgemäß, kann es passieren, daß es zu keiner oder zu einer Fehlkontaktierung mit den entsprechenden Kontakten im Gehäuse kommt. Auch beim Gebrauch bzw. der Handhabung des elektrischen oder elektronischen Gerätes kann es zu einem Verschieben der Leiterplatte kommen.

Aufgabe der Erfindung ist es, ein elektrisches oder elektronisches Gerät der eingangs genannten Art zur Verfügung zu stellen, bei dem in jedem Falle eine hinreichende Kontaktierung der Leiterplatte im eingebauten Zustand sichergestellt ist.

Diese Aufgabe ist erfindungsgemäß im wesentlichen dadurch gelöst, daß wenigstens eine Fixiereinrichtung vorgesehen ist, die von der Außenseite des Gehäuses in jeweils korrespondierende Öffnungen in der Leiterplatte und im Gehäuse eingesteckt ist. Die Verwendung der erfindungsgemäßen Fixiereinrichtung bietet nicht nur den Vorteil. daß in jedem Falle verhindert wird, daß beim Gebrauch bzw. Handhaben des elektrischen oder elektronischen Gerätes die Leiterplatte innerhalb des Gehäuses verschoben wird. Die Verwendung der Fixiereinrichtung stellt auch sicher, daß in jedem Falle eine ordnungsgemäße Kontaktierung der Leiterplatte mit den im Gehäuse befindlichen Kontakten gewährleistet ist. Dies erfolgt letztlich dadurch, daß ein Einstecken der Fixiereinrichtung in die Öffnungen im Gehäuse und der Leiterplatte nur dann möglich ist, wenn diese Öffnungen ausgefluchtet sind, was bedeutet, daß sich die Leiterplatte in dieser Stellung in der gewünschten Einbau- und Kontaktierungsposition befindet.

Die Erfindung eignet sich insbesondere bei elektrischen oder elektronischen Geräten, deren Gehäuse zumindest zweiteilig ausgebildet sind und einerseits ein die Leiterplatte aufnehmendes Oberteil und andererseits ein wenigstens eine Leiterplattenaufnahme zur Kontaktierung in der Leiterplatte aufweisendes Sockelteil aufweisen. Aufgrund der Teilbarkeit des Gehäuses besteht hierbei die Möglichkeit, die Leiterplatte zusammen mit dem Oberteil des Gehäuses zu entnehmen, ohne daß eine Busverbindung, die über das Sockelteil gebildet wird, unterbrochen wird. Da bei dieser Ausführungsform die Leiterplatte im eingebauten Zustand in der Leiterplattenaufnahme gehalten ist, kann also durch die wenigstens eine Fixiereinrichtung sichergestellt werden, daß die Leiterplatte beim Abnehmen des Oberteils aus der Leiterplattenaufnahme herausgezogen wird und nicht am Sockelteil verbleibt.

Wie zuvor bereits ausgeführt worden ist, eignet sich die Erfindung insbesondere bei elektrischen oder elektronischen Geräten, die für eine Daten- und/oder Energiebusverbindung zur Kontaktierung mit benachbarten, auf die Tragschiene aufgesetzten elektrischen oder elektronischen Geräten vorgesehen sind. Hierbei sind dann am Sokkelteil in Tragschienenlängsrichtung weisende Kontakte für die Daten- und/oder Energiebusverbindung zur Kontaktierung von benachbarten, auf die Tragschiene aufgesetzten und korrespondierende Kontakte aufweisenden elektrischen oder elektronischen Geräten vorgesehen.

Um einerseits das Einführen der Leiterplatte in das Gehäuse und andererseits das Einstecken der Fixiereinrichtung in die Öffnungen zu erleichtern, ist im Gehäuse eine Führung für die Leiterplatte vorgesehen.

Die Fixierung der Leiterplatte im Gehäuse läßt sich in besonders einfacher Weise dadurch realisieren, daß die Fixiereinrichtung lediglich in die Leiterplatte eingesteckt ist, ohne weiter mit der Leiterplatte verbunden zu sein. Insbesondere ist ein Verlöten mit der Leiterplatte nicht erforderlich. Um dabei eine sichere Verbindung zwischen der Leiterplatte und der Fixiereinrichtung zu erzielen, weist die Fixiereinrichtung wenigstens einen, vorzugsweise jedoch zwei in Tragschienenlängsrichtung erstreckende Einsteckschenkel auf, wobei am Einsteckschenkel wenigstens eine Verdickung vorgesehen ist, über die sich ein guter Reibschluß mit der korrespondierenden Öffnung in der Leiterplatte erzielen läßt.

Neben der Fixierungsfunktion kann die Fixiereinrichtung aber auch einen weiteren Zweck erfüllen, nämlich zum elektrischen Anschluß dienen. Häufig müssen nämlich an der Leiterplatte Zuführungskontakte befestigt werden. Dies kann ohne weiteres bei entsprechender Ausbildung über die Fixiereinrichtung erfolgen. Zu diesem Zweck sollte die Fixiereinrichtung wenigstens ein Klemmenelement in Form einer Anschlußklemme aufweisen. In diesem Falle kontaktiert der Einsteckschenkel mit einer Leiterbahn auf der Leiterplatte. Das elektrische oder elektronische Gerät hat dann auch die Funktion einer anreihbaren Klemme.

Damit die Fixiereinrichtung nicht über das elektrische oder elektronische Gerät seitlich übersteht, ist bei einer vorteilhaften Ausführungsform vorgesehen, daß die Fixiereinrichtung in einer korrespondierenden Aufnahme im Oberteil aufgenommen ist. Wenn bei dieser Ausführungsform die Fixiereinrichtung wenigstens ein Klemmenelement aufweist, also zum Anschluß von Zuführungskontakten dient, ist im Oberteil wenigstens eine Anschlußöffnung zum Einführen des Zuführungskontaktes in das Klemmenelement und wenigstens eine Betätigungsöffnung zur Betätigung des Klemmenelementes vorgesehen.

Damit die Fixiereinrichtung während des Gebrauchs des Klemmenelemtens keinen mechanischen Beanspruchungen unterliegt, die sich auf die Leiterplatte übertragen könnten, weist die Fixiereinrichtung einen aus dem Klemmenelement herausragenden Schenkel auf, von dem der Einsteckschenkel absteht. An dem Schenkel ist nun eine Stufe vorgesehen, während sich in der Aufnahme ein korrespondierender stufenförmiger Schlitz befindet, in dem die Stufe des Schenkels angeordnet ist und am Gehäuse anliegt. Eine etwaige Zug- oder Druckbelastung auf das Klemmenelement wird somit vom Gehäuse aufgenommen und nicht auf die Leiterplatte übertragen.

Damit die Fixiereinrichtung nicht aus dem elektrischen oder elektronischen Gerät herausfallen kann, ist schließlich eine Abdeckung für die Aufnahme vorgesehen, die lösbar mit dem Gehäuse verbindbar, vorzugsweise verrastbar ist.

Weitere Merkmale, Vorteile und Anwendungsmöglichkeiten der vorliegenden Erfindung ergeben sich aus der nachfolgenden Beschreibung von Ausführungsbeispielen anhand der Zeichnung und der Zeichnung selbst.

Es zeigt
- Fig. 1: eine perspektivische Ansicht eines auf eine Tragschiene aufgesetzten erfindungsgemäßen elektrischen oder elektronischen Gerätes,
- Fig. 2: eine perspektivische Ansicht einer anderen Ausführungsform eines erfindungsgemäßen elektrischen oder elektronischen Gerätes,
- Fig. 3: eine perspektivische Ansicht von Sockelteilen von erfindungsgemäßen elektrischen oder elektronischen Geräten,
- Fig. 4: eine andere perspektivische Ansicht von Sockelteilen von erfindungsgemäßen elektrischen oder elektronischen Geräten,
- Fig. 5: eine Vorderansicht im Schnitt eines Teils eines erfindungsgemäßen elektrischen oder elektronischen Gerätes,
- Fig. 6: eine Vorderansicht im Schnitt einer anderen Ausführungsform eines erfindungsgemäßen elektrischen oder elektronischen Gerätes,
- Fig. 7: eine perspektivische Ansicht der Art der Fixierung der Leiterplatte eines erfindungsgemäßen elektrischen oder elektronischen Gerätes unter Weglassung des Gehäuses,
- Fig. 8: eine perspektivische Ansicht von zwei Fixiereinrichtungen zur Fixierung der Leiterplatte und
- Fig. 9: eine perspektivische Ansicht eines Teils des Gehäuses eines erfindungsgemäßen elektrischen oder elektronischen Gerätes.

In den Fig. ist ein elektrisches oder elektronisches Gerät 1 dargestellt, das zum Aufsetzen auf eine als Hutschiene ausgebildete Tragschiene 2 vorgesehen ist. Das elektrische oder elektronische Gerät 1 selbst weist ein Gehäuse 3 auf, das aus einem isolierenden Material, insbesondere Kunststoff, besteht. Im Gehäuse 3 befindet sich eine Leiterplatte 4. Die Leiterplatte 4 ist in an sich bekannter Weise mit Leiterbahnen 5 ggf. auf beiden Leiterplattenseiten und mit nicht näher dargestellten elektronischen Bauteilen versehen. Des weiteren weist das elektrische oder elektronische Gerät 1 in Tragschienenlängsrichtung R weisende, als Messerkontakte ausgebildete Kontakte 6a auf der einen Seite 11a und korrespondierende, als Kontaktaufnahmen ausgebildete Kontakte 6b auf der anderen Seite 11b für eine Daten- und/oder Energiebusverbindung zur Kontaktierung von benachbarten, auf die Tragschiene 2 aufgesetzten und korrespondierende Kontakte aufweisenden weiteren Elektronikgeräten auf.

Elektrische oder elektronische Geräte 1 der zuvor beschriebenen Art können aufgrund ihrer Ausbildung auf einer Tragschiene 2 aneinandergereiht werden, wobei sich über die jeweiligen Kontakte 6a, 6b eine Daten- und/oder Energiebusverbindung ergibt. Das dargestellte elektrische oder elektronische Gerät 1 ist außerdem in Art einer anreihbaren Klemme ausgebildet und insbesondere für den Ex-Schutzbereich geeignet.

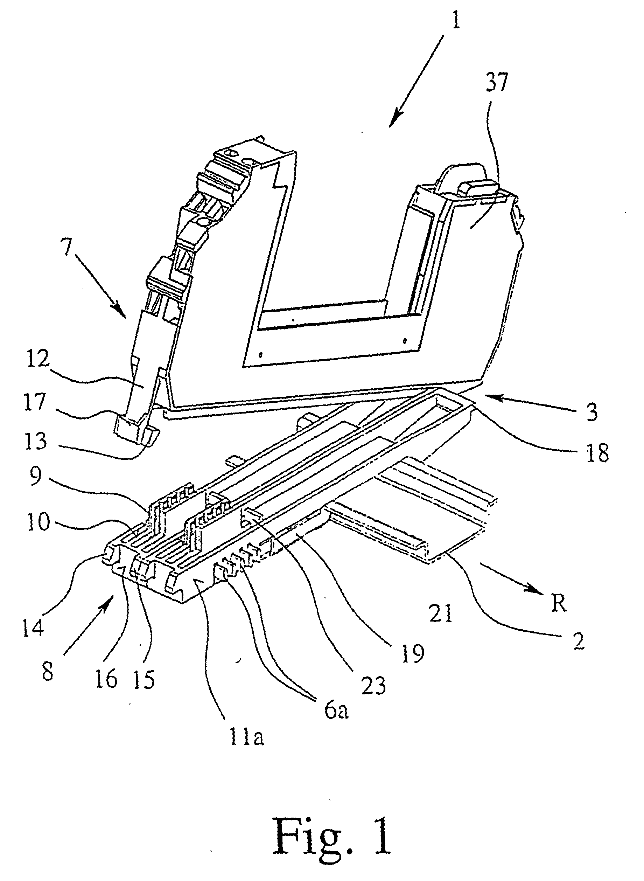

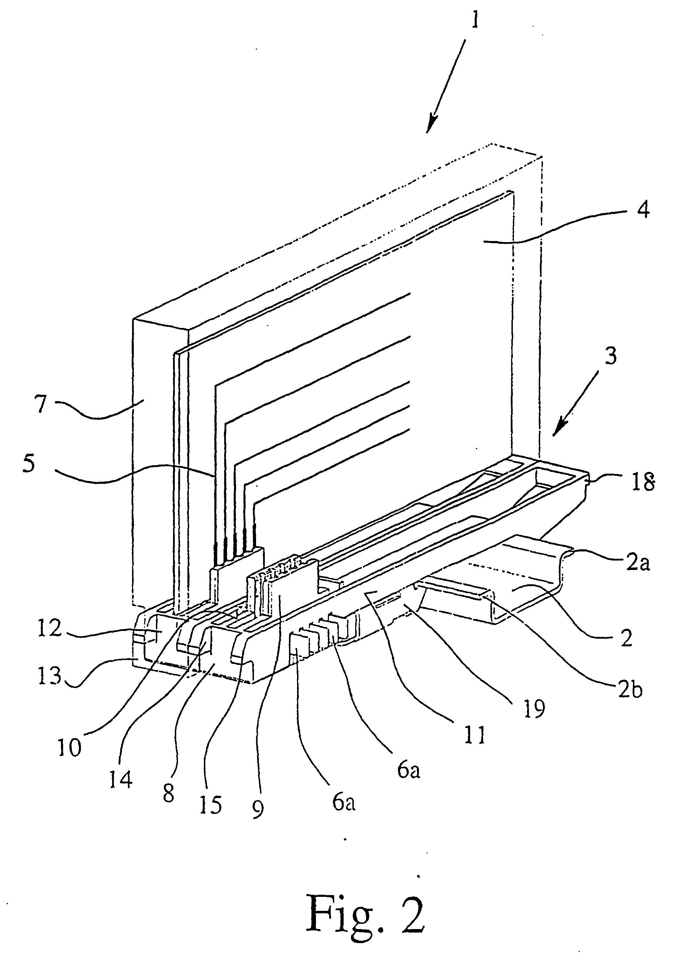

Im dargestellten Ausführungsbeispiel der Fig. 1 bis 5 ist das Gehäuse 3 zumindest zweiteilig ausgebildet ist. Dabei weist das Gehäuse 3 ein die Leiterplatte 4 aufnehmendes Oberteil 7 und ein die Kontakte 6a, 6b aufweisendes Sockelteil 8 auf. Zur Kontaktierung mit dem Sockelteil 8 weist dieses eine Leiterplattenaufnahme 9 auf, die über die Oberseite 10 des Sockelteils 8 übersteht. Die Kontakle in der Leiterplattenaufnahme 9 korrespondieren mit den Kontakten 6a, 6b in den Seiten 11a, 11b des Sockelteils 8.

Zur lösbaren Verbindung des Oberteils 7 mit dem Sockelteil 8 ist eine erste Verriegelung vorgesehen, die als Rastverbindung ausgebildet ist. Hierzu weist die erste Verriegelung einen federnden Rastarm 12 auf, der am Oberteil 7 vorgesehen ist. Der Rastarm 12, der nach unten hin über das Oberteil 7 übersteht, weist einen Rastabschnitt 13 auf, der mit zwei korrespondierenden Rasthaken 14, 15, die an der Stirnseite 16 des Sockelteils 8 vorgesehen sind, zusammenwirken. Die Rasthaken 14, 15 sowie der

Rastabschnitt 13 weisen jeweils Auflaufschrägen auf, um das Aufrasten zu erleichtern. Die beiden Rasthaken 14, 15 sind voneinander beabstandet, so daß der Rastarm im verrasteten Zustand zwischen den Rasthaken 14, 15 liegt. Zum Öffnen der Rastverbindung der ersten Verriegelung ist am Ende des Rastarms 12 ein Eingriffsabschnitt in Form einer Tasche 17 vorgesehen, in die ein Werkzeug, wie beispielsweise ein Schraubendreher, eingesetzt und mit dessen Hilfe der Rastarm 12 ausgefedert werden kann. Während an der einen Stirnseite des Gehäuses 3 die Rastverbindung vorgesehen ist, befindet sich an der anderen Stirnseite am Oberteil 7 ein nicht dargestellter Aufnahmeschlitz für einen korrespondierenden Vorsprung 18 am Sockelteil 8, so daß das Oberteil 7 auf das Sockelteil 8 aufschwenkbar ist.

Zur lösbaren Verbindung des Sockelteils 8 mit der Tragschiene 2 ist eine zweite Verriegelung vorgesehen. Wie das Oberteil 7 auf das Sockelteil 8 so ist auch das Sockelteil 8 auf die Tragschiene 2 aufschwenkbar. Zu diesem Zweck ist an der Unterseite 20 des Sockelteils 8 ein nicht näher dargestellter Schlitz zum Eingriff des korrespondierenden Vorsprungs 2a der Tragschiene 2 vorgesehen. Gegenüberliegend der Schwenkverbindung befindet sich am Sockelteil 8 ein federbelasteter Riegel 19, der zum einseitigen Untergreifen der Tragschiene 2 bzw. des korrespondierenden Vorsprungs 2b der Tragschiene 2 dient.

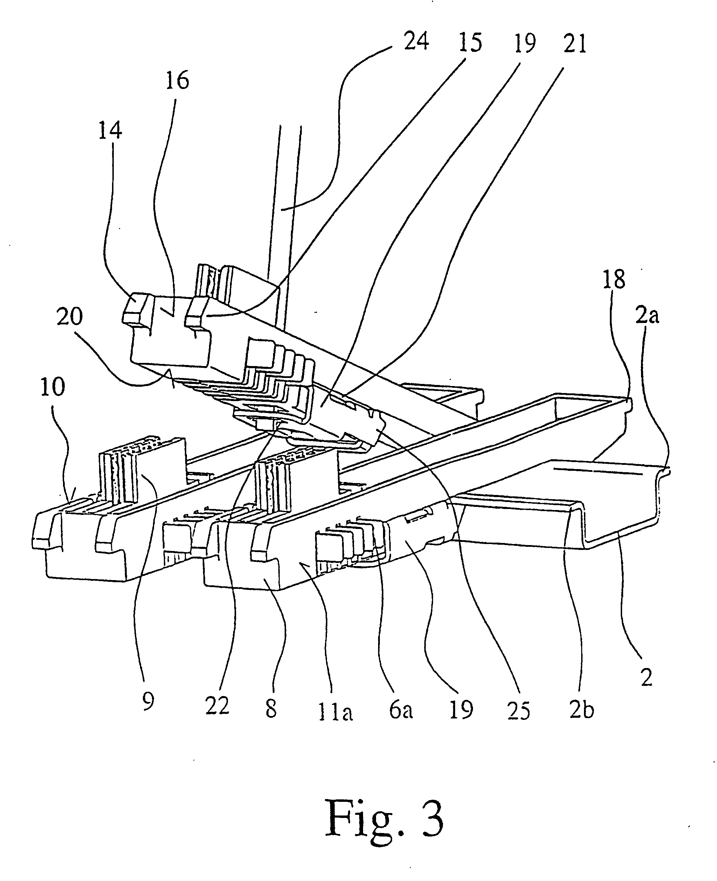

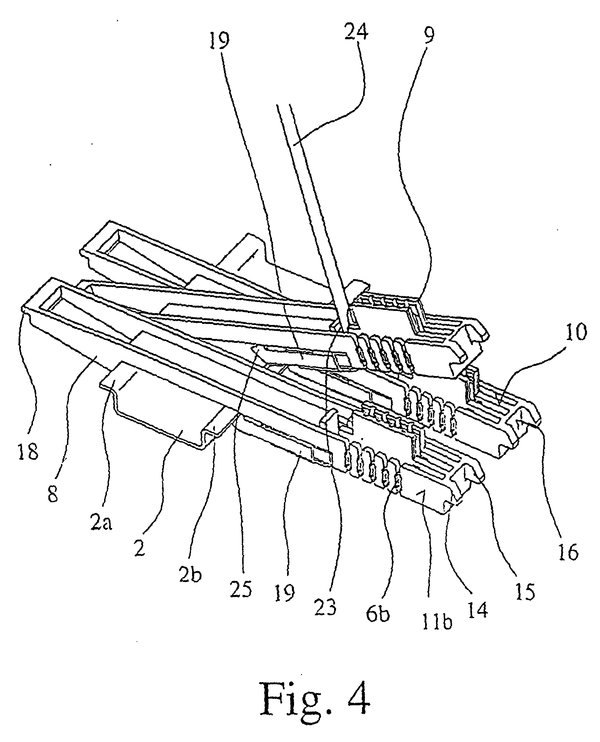

Der Riegel 19 ist an sich an der Unterseite 20 des Sockelteils 8 angeordnet. Die Form des Riegels 19 ist etwa U-förmig, wobei sich der Riegel 19 über die gesamte Unterseite 20 des Sockelteils 8 erstreckt. Die oberen Enden der U-Schenkel sind aufeinander zu abgewinkelt und greifen jeweils in einen korrespondierenden Schlitz 21 an den Seiten 11a, 11b am Sockelteil 8 ein. Hierdurch ist der Riegel 21 unverlierbar am Sokkelteil 8 gehalten. Am Riegel 19 befindet sich eine Betätigungsöffnung 22, während im Sockelteil 8 eine durchgehende, von der Oberseite 10 her zugängliche Einführöffnung 23 für ein Werkzeug 24, wie einen Schraubendreher, vorgesehen ist (vgl. insbesondere Fig. 3 und 4). Die Einführöffnung 23 ist dabei nur zugänglich, wenn das Oberteil 7 vom Sockelteil 8 abgenommen worden ist. Im Verriegelungszustand, in dem der Riegel 19 mit seinem Verriegelungsabschnitt 25 den Vorsprung 2b der Tragschiene 2 untergreift, sind die Betätigungsöffnung 22 und die Einführöffnung 23 versetzt zueinander angeordnet, wobei ein Einführen des Werkzeugs 24 in die Betätigungsöffnung 22 aber noch möglich ist. Durch ein weiteres Einführen des Werkzeugs 24 öffnet sich die Betätigungsöffnung 22 in die Einführöffnung 23, wobei der Riegel 19 entgegen der Federbelastung bewegt wird, bis der Verriegelungsabschnitt 25 den entsprechenden Vorsprung 2b der Tragschiene 2 nicht mehr untergreift und das Sockelteil 8 damit von der Tragschiene 2 abgeschwenkt werden kann.

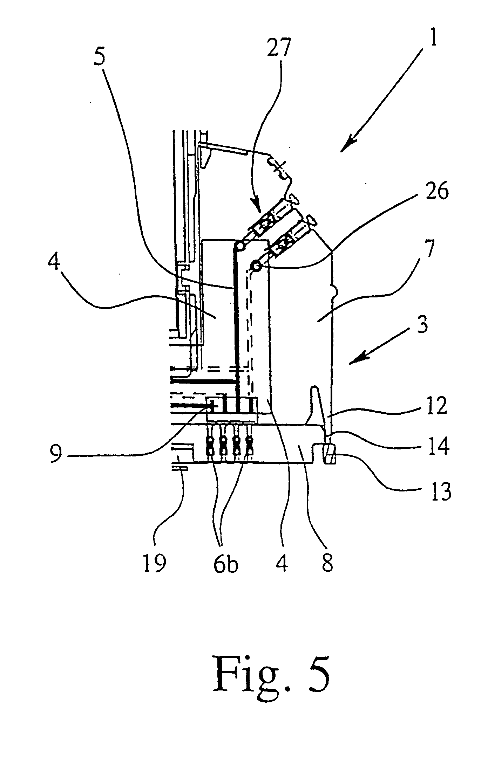

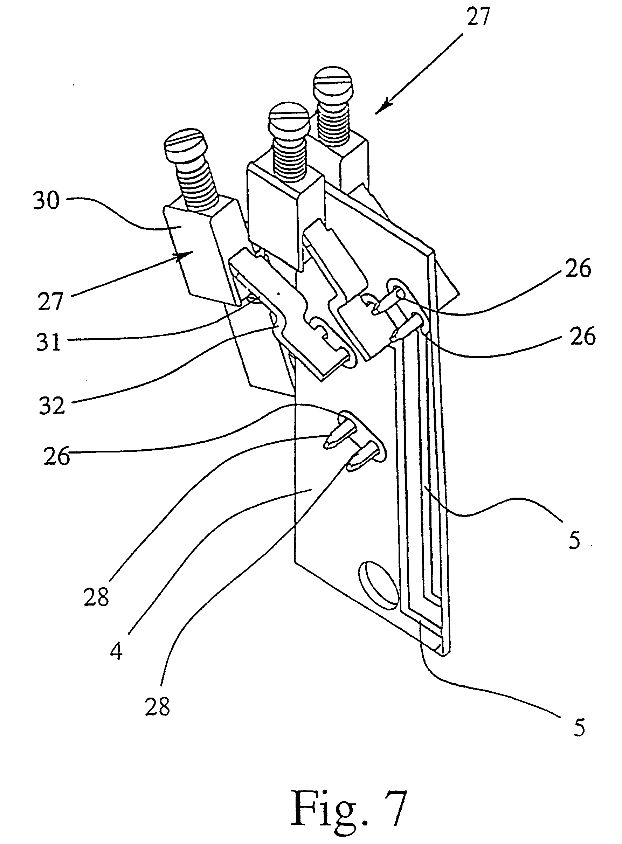

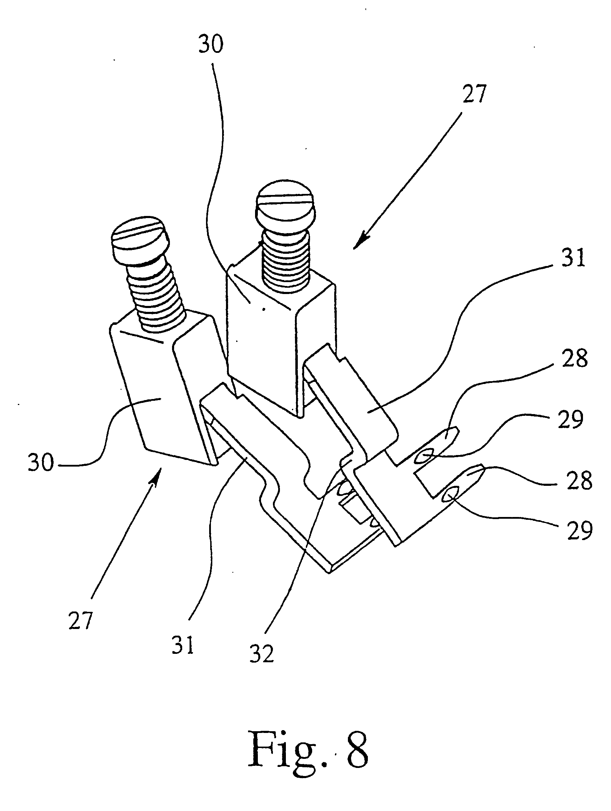

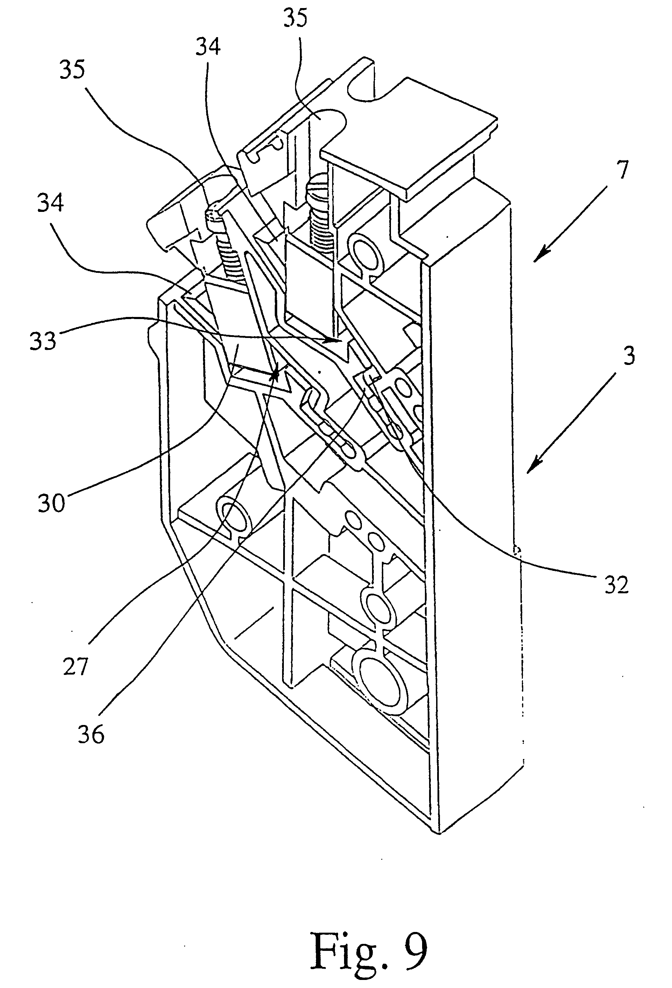

Die Leiterplatte 4 selbst ist im Gehäuse 3 bzw. im Oberteil 7 des Gehäuses 3 in einer Führung gehalten, die auch das Einschieben der Leiterplatte 4 beim Einbau erleichtert. Wie sich insbesondere aus den Fig. 5 bis 9 ergibt, sind in der Leiterplatte 4 und im Oberteil 7 jeweils korrespondierende Öffnungen 26 vorgesehen, die zum Einstekken wenigstens einer Fixiereinrichtung 27 von der Außenseite des Gehäuses 3 her dienen.

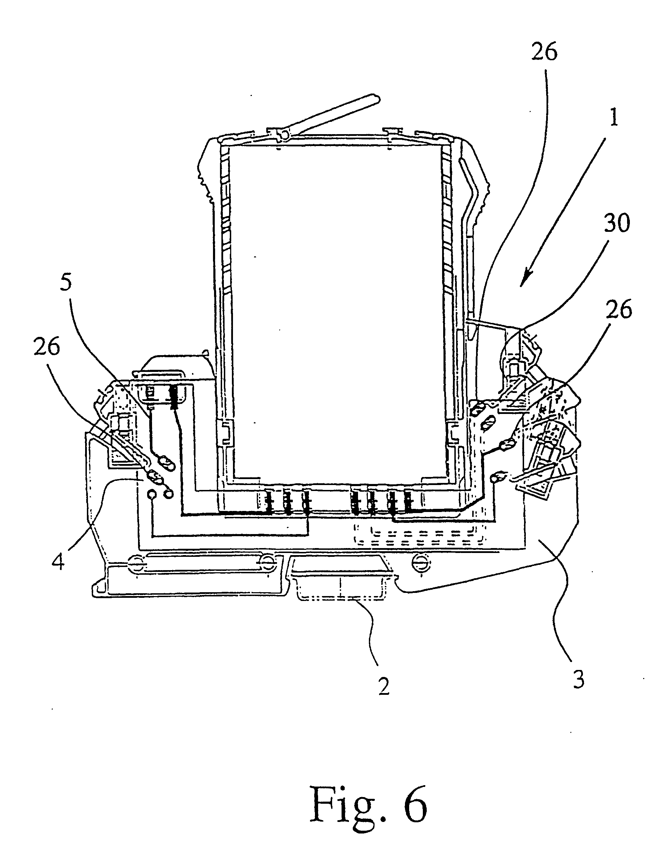

Obwohl die Verwendung von Fixiereinrichtungen 27 natürlich besonders vorteilhaft in Verbindung mit den erwähnten zweiteiligen Gehäusen 3 ist, können die Fixiereinrichtungen 27 auch zum Fixieren der Leiterplatte 4 in einem einteiligen Gehäuse 3 vorgesehen sein, wie dies in Fig. 6 dargestellt ist. Die Verbindung der einzelnen Fixiereinrichtungen 27 mit der Leiterplatte 4 erfolgt in jedem Falle lediglich über das Einstecken, ohne daß eine weitere Verbindung, insbesondere eine Verlötung erforderlich ist.

Zum Einstecken weist die Fixiereinrichtung 27 bei der in Fig. 5 dargestellten Ausführungsform einen Einsteckschenkel 28 auf, während bei den in den Fig. 6 bis 9 dargestellten Ausführungsformen jeweils zwei Einsteckschenkel 28 pro Fixiereinrichtung 27 vorgesehen sind. Die Einsteckschenkel 28 verlaufen etwa rechtwinklig zur Ebene der Leiterplatte 4 und damit koaxial zur Tragschienenrichtung R. Da die einzelnen Einsteckschenkel 28 lediglich in die Leiterplatte 4 eingesteckt sind, ist zur Verbesserung der Steckverbindung wenigstens eine Verdickung 29 am Einsteckschenkel 28 vorgesehen.

Neben ihrer Fixierungsfunktion dienen die einzelnen Fixiereinrichtungen 27 vorliegend aber auch zum Anschluß von Zuführungskontakten. Zu diesem Zweck ist am dem Einsteckschenkel 28 gegenüberliegenden Ende der Fixiereinrichtung 27 ein Klemmenelement 30 vorgesehen. Bei dem in den Fig. 6 bis 9 dargestellten Klemmenelement 30 handelt es sich vorliegend um eine Schraubklemme. Die Öffnungen 27 befinden sich jeweils im Bereich von Leiterbahnen 5, so daß sich beim Einstecken eines Einsteckschenkels 28 eine Kontaktierung mit der betreffenden Leiterbahn ergibt.

Der im Klemmenelement 30 vorhandene Kontaktschenkel ist aus dem Klemmenelement 30 als Schenkel 31 herausgeführt. Von dem Schenkel 31 etwa im rechten Winkel abgewinkelt sind die Einsteckschenkel 28. Vor der Abwinkelung der Einsteckschenkel 28 ist am Schenkel 31 eine Stufe 32 ausgebildet.

Die Fixiereinrichtungen 27 sind jeweils in korrespondierenden Aufnahmen 33 im Gehäuse 3 bzw. im Oberteil 7 des Gehäuses 3 aufgenommen. Zum Anschluß von Zuführungskontakten ist dabei für jede Fixiereinrichtung 27 eine Anschlußöffnung und zur Betätigung des Klemmelements 30 jeweils eine Betätigungsöffnung 35 vorgesehen. Korrespondierend zur Stufe 32 am Schenkel 31 ist im übrigen in der Aufnahme 33 ein korrespondierender stufenförmiger Schlitz 36 vorgesehen, in dem die Stufe 32 am Gehäuse 3 anliegt, so daß etwaige Druck- und Zugbelastungen auf das Gehäuse 3 übertragen werden.

Um die Aufnahme 33 verschließen zu können, weist das Gehäuse 3 bzw. das Oberteil 7 eine Abdeckung 37 auf, die lösbar mit dem Gehäuse 3 bzw. dem Oberteil 7 verbunden, insbesondere mit diesem verrastet werden kann.

## Patentansprüche

1. Elektrisches oder elektronisches Gerät (1) zum Aufsetzen auf eine Tragschiene (2), mit einem Gehäuse (3) und mit einer im Gehäuse (3) angeordneten Leiterplatte (4), **dadurch gekennzeichnet, daß** wenigstens eine Fixiereinrichtung (27) vorgesehen ist, die von der Außenseite des Gehäuses (3) in jeweils korrespondierende Öffnungen (26) in der Leiterplatte (4) und im Gehäuse (3) eingesteckt ist.

2. Elektrisches oder elektronisches Gerät nach Anspruch 1, **dadurch gekennzeichnet, daß** das Gehäuse (3) zumindest zweiteilig ausgebildet ist und ein die Leiterplatte (4) aufnehmendes Oberteil (7) und wenigstens ein eine Leiterplattenaufnahme (9) zur Kontaktierung mit der Leiterplatte (4) aufweisendes Sockelteil (8) vorgesehen sind.

3. Elektrisches oder elektronisches Gerät nach Anspruch 2, **dadurch gekennzeichnet, daß** am Sockelteil (8) in Tragschienenrichtung (R) weisende Kontakte (6a, 6b) für eine Daten- und/oder Energiebusverbindung zur Kontaktierung von benachbarten, auf die Tragschiene (2) aufgesetzten und korrespondierende Kontakte (6a, 6b) aufweisenden elektrischen oder elektronischen Geräten vorgesehen sind.

4. Elektrisches oder elektronisches Gerät nach einem der Ansprüche 1 bis 3, **dadurch gekennzeichnet, daß** im Gehäuse (3) eine Führung für die Leiterplatte (4) vorgesehen ist.

5. Elektrisches oder elektronisches Gerät nach einem der Ansprüche 1 bis 4, **dadurch gekennzeichnet, daß** die Fixiereinrichtung (27) zur Verbindung mit der Leiterplatte (4) lediglich in diese eingesteckt ist, ohne weiter mit der Leiterplatte (4) verbunden zu sein.

6. Elektrisches oder elektronisches Gerät nach Anspruch 5, **dadurch gekennzeichnet. daß** die Fixiereinrichtung (27) wenigstens einen, vorzugsweise zwei in Tragschienenlängsrichtung (R) ausgerichtete Einsteckschenkel (28) aufweist, und daß, vorzugsweise, am Einsteckschenkel (28) wenigstens eine Verdickung (29) vorgesehen ist.

7. Elektrisches oder elektronisches Gerät nach einem der Ansprüche 1 bis 6, **dadurch gekennzeichnet, daß** die Fixiereinrichtung (27) zum elektrischen Anschluß ausgebildet ist, daß, vorzugsweise, die Fixiereinrichtung (27) wenigstens ein Klemmenelement (30) aufweist und daß der Einsteckschenkel (28) mit wenigstens einer Leiterbahn (5) der Leiterplatte (4) kontaktiert.

8. Elektrisches oder elektronisches Gerät nach einem der Ansprüche 1 bis 7 oder nach Anspruch 7, **dadurch gekennzeichnet, daß** die Fixiereinrichtung (27) in einer korrespondierenden Aufnahme (33) im Gehäuse (3) aufgenommen ist und daß, vorzugsweise, im Gehäuse (3) wenigstens eine Anschlußöffnung (34) und wenigstens eine Betätigungsöffnung (35) zum Klemmenelement (30) vorgesehen sind.

9. Elektrisches oder elektronisches Gerät nach Anspruch 7 oder 8, **dadurch gekennzeichnet, daß** die Fixiereinrichtung (27) einen aus dem Klemmenelement (30) herausragenden Schenkel (31) aufweist, von dem der Einsteckschenkel (28) absteht, und daß am Schenkel (31) eine Stufe (32) und in der Aufnahme (33) ein korrespondierender stufenförmiger Schlitz (36) vorgesehen sind, in dem die Stufe (32) angeordnet ist und am Gehäuse (3) anliegt.

10. Elektrisches oder elektronisches Gerät nach Anspruch 8 oder 9, **dadurch gekennzeichnet, daß** eine Abdeckung (37) für die Aufnahme (33) vorgesehen ist und daß, vorzugsweise, die Abdeckung (37) mit dem Gehäuse (3) lösbar verbindbar, vorzugsweise verrastbar ist.

## Claims

1. Electrical or electronic device (1) for placement on a support rail (2), with a housing (3) and with a circuit board (4) located in the housing (3), **characterized in that** at least one fixing means (27) is provided which is inserted from the outside of the housing (3) into the corresponding openings (26) in the circuit board 84) and in the housing (3).

2. Electrical or electronic device according to claim 1, **characterized in that** the housing (3) is made in at least two parts and there is a top part (7) which holds the circuit board (4) and there is at least one base part (8) which has a circuit board receiver (9) for making contact with the circuit board (4).

3. Electrical or electronic device according to claim 2, **characterized in that** there are contacts (6a, 6b) on the base part (8) which point in the direction (R) of the support rail for a data and/or power bus connection for making contact with adjacent electrical or electronic devices which have the corresponding contacts (6a, 6b) and which are placed on the support rail (2).

4. Electrical or electronic device according to any one of claims 1 to 3, **characterized in that** there is a guide for the circuit board (4) in the housing (3).

5. Electrical or electronic device according to any one of claims 1 to 4, **characterized in that** the fixing means (27) is inserted simply into the circuit board (4) for connection to it without being further connected to the circuit board (4).

6. Electrical or electronic device according to claim 5, **characterized in that** the fixing means (27) has at least one, preferably two insertion legs (28) aligned in the lengthwise direction (R) of the support rail, and that preferably there is at least one thickened area (29) on the insertion leg (28).

7. Electrical or electronic device according to any one of claims 1 to 6, **characterized in that** the fixing means (27) is made for electrical connection, that preferably the fixing means (27) has at least one terminal element (30), and that the insertion leg (28) makes contact with at least one printed conductor (5) of the circuit board (4).

8. Electrical or electronic device according to any one of claims 1 to 7, or according to claim 7, **characterized in that** the fixing means (27) is held in a corresponding receiver (33) in the housing (3) and that preferably there is at least one connection opening (34) and at least one actuation opening (35) for the terminal element (30) in the housing (3).

9. Electrical or electronic device according to claim 7 or 8, **characterized in that** the fixing means (27) has a leg (31) which projects out of the terminal element (30) and from which the insertion leg (28) projects, and that there is a step (32) on the leg (31) and there is a corresponding step-shaped slot (36) in the receiver (33) in which the step (32) is located and adjoins the housing (3).

10. Electrical or electronic device according to claim 8 or 9, **characterized in that** there is a cover (37) for the receiver (33) and that preferably the cover (37) can be detachably connected to the housing (3), preferably can be locked.

## Revendications

1. Appareil électrique ou électronique (1) à poser sur un rail porteur (2), avec un boîtier (3) et avec une plaque conductrice (4) disposée dans le boîtier (3), **caractérisé en ce qu'**au moins un système de fixation (27), qui est branché à partir du côté extérieur du boîtier (3) dans des orifices respectifs appropriés (26) de la plaque conductrice (4) et du boîtier (3), est prévu.

2. Appareil électrique ou électronique selon la revendication 1, **caractérisé en ce que** le boîtier (3) est formé d'au moins deux parties et qu'une pièce supérieure (7) recevant la plaque conductrice (4) et au moins une pièce de base (8) présentant un support (9) de plaque conductrice pour le contact avec la plaque conductrice (4) sont prévues.

3. Appareil électrique ou électronique selon la revendication 2, **caractérisé en ce que**, sur la pièce de base (8) dans le sens du rail porteur (R), des contacts indicateurs (6a, 6b) pour une liaison bus de données et/ou d'énergie pour le contact avec des appareils électriques ou électroniques voisins, posés sur le rail porteur (2) et présentant des contacts correspondants (6a, 6b) sont prévus.

4. Appareil électrique ou électronique selon une des revendications 1 à 3, **caractérisé en ce que**, dans le boîtier (3), un guide pour la plaque conductrice (4) est prévu.

5. Appareil électrique ou électronique selon une des revendications 1 à 4, **caractérisé en ce que** le système de fixation (27) pour la liaison avec la plaque conductrice (4) est simplement branché dans celle-ci, sans être autrement relié à la plaque conductrice (4).

6. Appareil électrique ou électronique selon la revendication 5, **caractérisé en ce que** le système de fixation (27) présente au moins un, de préférence deux, éléments de branchement (28) alignés dans le sens du rail porteur (R) et que, de préférence, sur l'élément de branchement (28), au moins une surépaisseur (29) est prévue.

7. Appareil électrique ou électronique selon une des revendications 1 à 6, **caractérisé en ce que** le système de fixation (27) est conçu pour un raccordement électrique, que, de préférence, le système de fixation (27) présente au moins un élément de blocage (30) et que l'élément de branchement (28) est contacté au moyen d'au moins une bande conductrice (5) de la plaque conductrice (4).

8. Appareil électrique ou électronique selon une des revendications 1 à 7 ou selon la revendication 7, **caractérisé en ce que** le système de fixation (27) est inséré dans un support approprié (33) dans le boîtier (3) et que, de préférence, dans le boîtier (3), au moins un orifice de raccordement (34) et au moins un orifice d'actionnement (35) pour l'élément de blocage (30) sont prévus.

9. Appareil électrique ou électronique selon la revendication 7 ou 8, **caractérisé en ce que** le système de fixation (27) présente un élément (31) débordant de l'élément de blocage (30), dont dépasse l'élément de branchement (28) et que, sur l'élément (31), un échelon (32) et, dans le support (33), une fente correspondante (36) en forme de cran, dans laquelle le cran (32) est disposé et repose sur le boîtier (3), sont prévus.

10. Appareil électrique ou électronique selon la revendication 8 ou 9, **caractérisé en ce qu'**un capot (37) est prévu pour le support (33) et que, de préférence, le capot (37) peut être relié avec le boîtier (3) avec possibilité de se détacher, de préférence de se déboîter.
